# EUROPEAN PATENT APPLICATION

(11) **EP 4 398 445 A1**
(43) Date of publication of application: **10.07.2024**
(21) Application number: 23220250.7
(22) Date of filing: 27.12.2023
(51) Int. Cl.: H02J 7/00, H03K 17/18

(54) **SWITCH DRIVING CIRCUIT, BATTERY MANAGEMENT SYSTEM, BATTERY PACK, AND ELECTRICAL DEVICE**

(30) Priority: 30.12.2022 CN 202211724277
(71) Applicant: DONGGUAN POWERAMP TECHNOLOGY LIMITED, Dongguan City, Guangdong Province 523000 (CN)
(72) Inventor: BAI, Jinzhu, Dongguan City, Guangdong Province 523000 (CN); CHEN, Yong, Dongguan City, Guangdong Province 523000 (CN)
(74) Representative: Icosa

(57) **Abstract**

This application discloses a switch driving circuit, a battery management system, a battery pack, and an electrical device. The switch driving circuit includes: a charging switch (11) and a discharging switch (12) that are connected in series between a discharging terminal (P+/P-) and a cell module (B+/B-). A driving voltage generation module (20), the charging switch (11), and the discharging switch (12) are electrically connected to a first node (N1). The first node (N1) is electrically connected to an isolation ground end (GND1). The driving voltage generation module (20) is configured to boost an input voltage of the driving voltage generation module and output a driving voltage (Vdri). An isolation switch (30) is electrically connected to an output end of the driving voltage generation module (20) and a control end of the charging switch (11) and/or a control end of the discharging switch (12). The isolation switch (30) is configured to perform conduction in response to a control signal, and output the driving voltage (Vdri) to the control end of the charging switch (11) and/or the control end of the discharging switch (12).

## Description

### TECHNICAL FIELD

This application relates to the field of battery technology, and in particular, to a switch driving circuit, a battery management system, a battery pack, and an electrical device.

### BACKGROUND

With the development of new energy technology, batteries are applied more widely. In the charge and discharge control of a battery product, the on/off state is usually controlled by a switching device such as MOSFET (Metal-Oxide-Semiconductor Field-Effect Transistor, Metal-Oxide-Semiconductor Field-Effect Transistor) currently.

In the related art, in order for the switching device to exercise the control, a driving circuit is usually disposed to provide a corresponding driving voltage that drives the switching device to switch between the on-state and the off-state.

### SUMMARY

Some embodiments of this application provide a switch driving circuit, a battery management system, a battery pack, and an electrical device to alleviate the technical problem of electromagnetic interference caused by external static electricity or interference signals transmitted to a logic control circuit through a driving circuit of a charging switch or a discharging switch.

According to a first aspect of some embodiments of this application, an embodiment of this application provides a switch driving circuit. The switch driving circuit includes: a charging switch and a discharging switch, where the charging switch and the discharging switch are configured to be connected in series between a discharging terminal and a polarity terminal of a cell module; a driving voltage generation module, where the driving voltage generation module, the charging switch, and the discharging switch are electrically connected to a first node, the first node is electrically connected to an isolation ground end, and the driving voltage generation module is configured to receive and convert a voltage of the cell module or a power supply voltage and generate a driving voltage; and an isolation switch, where an input end of the isolation switch is electrically connected to an output end of the driving voltage generation module, and an output end of the isolation switch is electrically connected to a control end of the charging switch and/or a control end of the discharging switch. The isolation switch is configured to perform conduction in response to a control signal, and output the driving voltage to the control end of the charging switch and/or output the driving voltage to the control end of the discharging switch. By disposing the isolation switch, a low-voltage control signal is isolated from the switch driving voltage signal, thereby alleviating signal interference between the logic control circuit and the switch driving circuit, and enhancing the stability and reliability of the switch driving circuit.

In some embodiments, the driving voltage generation module includes: a voltage converter and a transformer. The input end of the voltage converter is configured to be electrically connected to the polarity terminal of the cell module or a power supply, so as to receive a voltage of the cell module or a power supply voltage. An input end of the transformer is electrically connected to an output end of the voltage converter. A first output end of the transformer is electrically connected to the first node, and a second output end of the transformer is electrically connected to the isolation switch. The transformer is configured to output the driving voltage. The voltage converter and the transformer enable receiving and converting the voltage of the cell module or the power supply voltage to generate a driving voltage. The transformer can isolate the signals on two sides to avoid signal interference between the voltage of the cell module or the power supply voltage and the driving voltage.

In some embodiments, the voltage converter includes: a DC-to-DC converter, where an input end of the DC-to-DC converter is configured to be electrically connected to the polarity terminal of the cell module or the power supply, and an output end of the DC-to-DC converter is electrically connected to the input end of the transformer. Alternatively, the voltage converter includes: a DC-to-DC converter and a power supply driving circuit, where an input end of the DC-to-DC converter is configured to be electrically connected to the polarity terminal of the cell module or the power supply, an output end of the DC-to-DC converter is electrically connected to the power supply driving circuit, and an output end of the power supply driving circuit is electrically connected to the input end of the transformer. Alternatively, the voltage converter includes: a power supply driving circuit, where an input end of the power supply driving circuit is configured to be electrically connected to the polarity terminal of the cell module or the power supply, and an output end of the power supply driving circuit is electrically connected to the input end of the transformer. By disposing the DC-to-DC converter or the power supply driving circuit, the voltage of the cell module or the power supply voltage can be transformed correspondingly to obtain a primary-side voltage that meets a voltage transformation requirement, and then the primary-side voltage is transformed by the transformer to obtain a driving voltage.

In some embodiments, the isolation switch includes: an enabling end, an input end, and an output end. Both the output end of the isolation switch and the input end of the isolation switch are isolated from the enabling end of the isolation switch, the input end of the isolation switch is electrically connected to the output end of the driving voltage generation module, and the output end of the isolation switch is electrically connected to the control end of the charging switch and the control end of the discharging switch separately. Alternatively, among the two isolation switches, each isolation switch includes: an enabling end, an input end, and an output end. Both the output end of the isolation switch and the input end of the isolation switch are isolated from the enabling end of the isolation switch, and the input end of the isolation switch is electrically connected to the output end of the driving voltage generation module. The output end of one isolation switch is electrically connected to the control end of the charging switch, and the output end of the other isolation switch is electrically connected to the control end of the discharging switch. By disposing the isolation switch, the input end and the output end can be isolated from the control end to prevent the voltage signal on the switch driving circuit from flowing to the logic control circuit.

In some embodiments, the switch driving circuit further includes: at least one enabling circuit. An input end of the enabling circuit is electrically connected to an analog front end and/or a microcontroller unit, and an output end of the enabling circuit is electrically connected to the enabling end of the isolation switch. The enabling circuit is configured to output an enabling signal to the isolation switch in response to a control signal output by the analog front end and/or a control signal output by the microcontroller unit. By disposing the enabling circuit, the enabling signal can be output in response to the control signal to drive the isolation switch to provide a driving voltage for the charging switch and the discharging switch.

In some embodiments, the switch driving circuit further includes: a driving voltage detection module. The driving voltage detection module is electrically connected between the control end of the charging switch and the microcontroller unit, and/or the driving voltage detection module is electrically connected between the control end of the discharging switch and the microcontroller unit. The driving voltage detection module is configured to output a detection signal in response to the driving voltage, and the detection signal is used for indicating a relationship between the driving voltage and a threshold voltage. By disposing the driving voltage detection module, the driving voltage can be detected, so that the microcontroller unit can determine the relationship between the driving voltage and the threshold voltage based on a detection result.

In some embodiments, the driving voltage detection module includes: a first voltage regulator and a first isolation element, where a first end of the first voltage regulator is electrically connected to the control end of the charging switch, and a second end of the first voltage regulator is electrically connected to the isolation ground end by the first isolation element; and/or, the driving voltage detection module includes: a second voltage regulator and a second isolation element, where a first end of the second voltage regulator is electrically connected to the control end of the discharging switch, and a second end of the second voltage regulator is electrically connected to the isolation ground end by the second isolation element. By disposing the voltage regulator, the relationship between the driving voltage and a breakdown voltage can be determined based on the breakdown voltage of the voltage regulator. The isolation element can isolate the driving voltage from the microcontroller unit to avoid signal interference between the driving voltage and the microcontroller unit.

In some embodiments, the first isolation element includes: an optocoupler and a first resistor, where an input end of the optocoupler and the first resistor are connected in series between the second end of the first voltage regulator and the isolation ground end, and an output end of the optocoupler is electrically connected to the microcontroller unit; and/or, the second isolation element includes: a optocoupler and a first resistor, where an input end of the optocoupler and the first resistor are connected in series between the second end of the second voltage regulator and the isolation ground end, and an output end of the optocoupler is electrically connected to the microcontroller unit. By limiting the current, the first resistor can prevent an excessive current that affects normal operation of the optocoupler. In this way, the optocoupler can send a corresponding detection signal to the microcontroller unit based on the regulated driving voltage.

In some embodiments, the driving voltage detection module further includes: at least one first diode, where the first diode is electrically connected between the control end of the charging switch and the first voltage regulator; and/or, the first diode is electrically connected between the control end of the discharging switch and the second voltage regulator. By disposing a diode, the diode can limit the direction of the current and prevent a reverse current from affecting the conduction status of the charging switch or the discharging switch.

In some embodiments, the switch driving circuit further includes: a pre-discharging module. The pre-discharging module includes a pre-discharging switch and a second resistor that are connected in series, and the pre-discharging module is connected in parallel to the discharging switch. By disposing the pre-discharging module, the current can be limited at the moment of connecting a load to the cell module, so as to avoid damage to the load caused by an excessive instantaneous discharging current.

In some embodiments, the switch driving circuit includes: a plurality of switch units. Each of the switch units includes a charging switch and a discharging switch that are connected in series. The switch unit is configured to be electrically connected between the discharging terminal and the polarity terminal of the cell module. The plurality of switch units are connected in parallel. The first node is included between the charging switch and the discharging switch connected in series in each switch unit. The output end of the driving voltage generation module is electrically connected to the isolation ground end by the first node. The isolation switch is electrically connected to the control end of each charging switch and the control end of each discharging switch. By disposing a plurality of switch units in parallel with each other, the plurality of switch units can be used to synchronously charge and discharge the cell module, thereby preventing a charging power and a discharging power of the cell module from being limited by a single charging switch and a single discharging switch.

According to a second aspect of some embodiments of this application, an embodiment of this application provides a battery management system, including the switch driving circuit according to the first aspect.

According to a third aspect of some embodiments of this application, an embodiment of this application provides a battery pack, including a cell module and the battery management system according to the second aspect. The cell module is electrically connected to the battery management system.

According to a fourth aspect of some embodiments of this application, an embodiment of this application provides an electrical device, including the battery pack according to the third aspect.

In the switch driving circuit, the battery management system, the battery pack, and the electrical device disclosed in some embodiments of this application, the driving voltage generation module, the charging switch, and the discharging switch are connected to the first node, and the driving voltage generation module boosts a voltage of the first node to obtain a driving voltage. The isolation switch can connect the output end of the driving voltage generation module to the control end of the charging switch and/or the control end of the discharging switch upon receiving a control signal, so that the charging switch and the discharging switch can receive the driving voltage. The charging switch and the discharging switch are turned on upon receiving the driving voltage, thereby connecting the cell module and the discharging terminal so that the cell module starts a charging or discharging process. The isolation switch can output a driving voltage in response to the control signal, so as to drive the charging switch and/or the discharging switch to turn on, and can isolate a low-voltage control signal from the switch driving voltage signal, thereby avoiding signal interference between the logic control circuit and the switch driving circuit, and enhancing the stability and reliability of the switch driving circuit.

### BRIEF DESCRIPTION OF DRAWINGS

To describe the technical solutions of some embodiments of this application more clearly, the following outlines the drawings to be used in some embodiments of this application. Evidently, the drawings outlined below are merely a part of embodiments of this application.
FIG. 1 is a schematic structural diagram of a switch driving circuit according to an embodiment of this application;
FIG. 2 is a schematic structural diagram of a switch driving circuit according to another embodiment of this application;
FIG. 3 is a schematic structural diagram of a switch driving circuit according to still another embodiment of this application;
FIG. 4 is a schematic structural diagram of a switch driving circuit according to yet another embodiment of this application;
FIG. 5 is a schematic structural diagram of a switch driving circuit according to still another embodiment of this application;
FIG. 6 is a schematic structural diagram of a switch driving circuit according to yet another embodiment of this application;
FIG. 7 is a schematic structural diagram of a switch driving circuit according to still another embodiment of this application;
FIG. 8 is a schematic structural diagram of a switch driving circuit according to yet another embodiment of this application;
FIG. 9 is a schematic structural diagram of a switch driving circuit according to still another embodiment of this application;
FIG. 10 is a schematic structural diagram of a switch driving circuit according to yet another embodiment of this application;
FIG. 11 is a schematic structural diagram of a switch driving circuit according to still another embodiment of this application; and
FIG. 12 is a schematic structural diagram of a switch driving circuit according to yet another embodiment of this application.

### List of reference numerals:

10. switch unit; 11. charging switch; 12. discharging switch; 13. pre-discharging switch; 20. driving voltage generation module; 30. isolation switch; N1. first node; P+. positive discharging port; P-. negative discharging port; B+. main positive electrode; B-. total negative electrode; 21. voltage converter; 211. DC-to-DC converter; 212. power supply driving circuit; 22. transformer; 31. enabling circuit; 40. driving voltage detection module; 41. first voltage regulator; 42. first isolation element; 43. second voltage regulator; 44. second isolation element; MCU. microcontroller unit; 60. power supply; OC. optocoupler; R1. first resistor; R2. second resistor; D1. first diode; GND1. isolation ground end.

### DETAILED DESCRIPTION OF EMBODIMENTS

The following specific embodiments are illustrative rather than restrictive, and are intended to provide a basic understanding of this application but not to identify key or decisive elements of this application or to limit the scope of protection.

In the description hereof, a "connection" may be a direct connection, or may be an indirect connection implemented through an intermediary, or may be internal communication between two components. A person of ordinary skill in the art is able to understand the specific meanings of the terms in this application according to specific situations.

Some embodiments of this application disclose a switch driving circuit, a battery management system, a battery pack, and an electrical device. The specific implementation of some embodiments of this application is described in further detail below with reference to drawings.

### Switch driving circuit

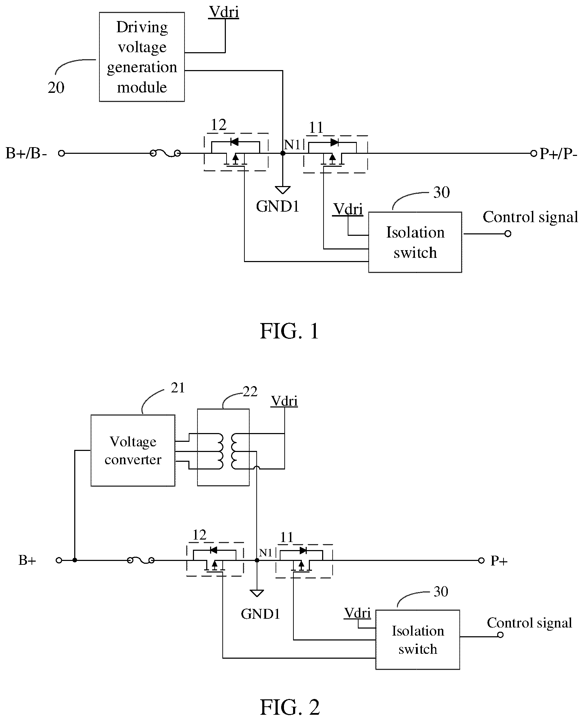

FIG. 1 is a schematic diagram of a modular structure of a switch driving circuit according to an embodiment of this application. As shown in FIG. 1, the switch driving circuit includes a charging switch 11, a discharging switch 12, a driving voltage generation module 20, and an isolation switch 30. The charging switch 11 and the discharging switch 12 may are connected in series between a discharging terminal and a polarity terminal of a cell module. The discharging terminal may be a positive discharging port P+ or a negative discharging port P- of a battery pack. The polarity terminal of the cell module may be a main positive electrode B+ of the cell module, or a main negative electrode B- of the cell module. In some embodiments, the charging switch 11 and the discharging switch 12 may be connected in series between the main positive electrode B+ of the cell module and the positive discharging port P+ of the battery pack. In some other embodiments, the charging switch 11 and the discharging switch 12 may be connected in series between the main negative electrode B- of the cell module and the negative discharging port P- of the battery pack.

The driving voltage generation module 20, the charging switch 11, and the discharging switch 12 are electrically connected to a first node N1. The first node N1 is electrically connected to the isolation ground terminal GND1. The driving voltage generation module 20 may receive an input voltage through an input end, and transform the input voltage, so as to output a driving voltage Vdri at an output end. Understandably, the driving voltage Vdri output by the driving voltage generation module 20 may be a voltage higher than the voltage of the first node N1. In an embodiment, a difference between the driving voltage Vdri and the voltage of the first node N1 may be used as a voltage that drives the charging switch 11 and the discharging switch 12 to turn on.

The isolation switch 30 is electrically connected to an output end of the driving voltage generation module 20. The isolation switch 30 may be electrically connected to a control end of the charging switch 11, or may be electrically connected to a control end of the discharging switch 12, or may be electrically connected to the control end of the charging switch 11 and the control end of the discharging switch 12 separately.

The isolation switch 30 can receive a control signal and can be turned on in response to the control signal, so as to output the driving voltage Vdri, which is output by the driving voltage generation module 20, to the control end of the charging switch 11 and/or the control end of the discharging switch 12.

When the isolation switch 30 is electrically connected to the control end of the charging switch 11, the isolation switch 30 outputs the driving voltage Vdri to the control end of the charging switch 11, so as to control, through the driving voltage Vdri, the charging switch 11 to turn on. Similarly, when the isolation switch 30 is electrically connected to the control end of the discharging switch 12, the isolation switch 30 can output the driving voltage Vdri, so as to control the discharging switch 12 to turn on. If the isolation switch 30 is electrically connected to both the control end of the charging switch 11 and the control end of the discharging switch 12, the isolation switch 30 can control, through the driving voltage Vdri, the charging switch 11 and the discharging switch 12 to turn on together.

When the charging switch 11 and the discharging switch 12 are turned on, the cell module can be connected to a discharging port of the battery pack to charge or discharge the battery pack. For example, when a load is connected to the discharging port, the cell module is enabled to supply power to the load through the discharging port of the battery pack. When a charging device is connected to the discharging port, the charging device can be connected to the cell module, and the voltage output by the charging device can be used to charge the cell module, so as to charge the battery pack.

A power switching device may be a MOSFET (Metal-Oxide-Semiconductor Field-Effect Transistor, metal-oxide-semiconductor field-effect transistor), IGBT (Insulated gate bipolar transistor, insulated gate bipolar transistor), a BJT (Bipolar Junction Transistor, bipolar junction transistor), GTO (Gate-Turn-Off Thyristor, gate-turn-off thyristor), PD (Power Diode, power diode), or the like. In some embodiments, the charging switch 11 and the discharging switch 12 each may be a MOSFET. Because the on-state and off-state of the MOSFET are related to a voltage difference between the gate and source of the MOSFET, in order to drive the MOSFET to turn on, a driving voltage needs to be provided to the gate of the MOSFET.

The isolation switch 30 can receive a control signal and can be turned on in response to the control signal, so as to output the driving voltage Vdri to the charging switch 11 and/or the discharging switch 12 to control the on-state or off-state of the charging switch 11 or discharging switch 12. In an embodiment, the control signal received by the isolation switch 30 may be a logic signal such as a control signal output by an analog front end (AFE) or a control signal output by a microcontroller unit. In some embodiments of this application, the control signals output by the analog front end and the microcontroller unit may be logic signals. The voltage of the logic signals may be 3.3 V, 5 V, 0 V, or the like. Compared with the voltage across the cell module, the voltage of the control signals is lower than the voltage of the cell module and also lower than the driving voltage Vdri.

Because the input voltage at the input end and the output voltage at the output end of the isolation switch 30 are the relatively high driving voltage Vdri, the control signal received by the enabling end is a logic signal with a relatively low voltage (for example, a control signal with a voltage of 3.3 V or 5 V). The isolation switch 30 isolates both the input end and the output end from the enabling end, thereby preventing the voltage signal of the switch driving circuit from flowing to the logic control circuit, and reducing the impact on the components (such as analog front end AFE and microcontroller unit) of the logic control circuit and the circuit. In addition, the isolation switch 30 can also prevent an external interference signal from being transmitted to the logic control circuit through a switch driving circuit, thereby reducing EMC (Electromagnetic Compatibility, electromagnetic compatibility) risks. In some optional embodiments, the isolation switch 30 may be an optocoupler, an optical MOS relay, an isolation chip, or the like.

In an embodiment of this application, the driving voltage generation module 20, the charging switch 11, and the discharging switch 12 are connected to the first node N1, and the driving voltage generation module 20 transforms the input voltage that is input to the driving voltage generation module 20, so as to obtain the driving voltage Vdri. The isolation switch 30 can connect the output end of the driving voltage generation module 20 to the control end of the charging switch 11 and/or the control end of the discharging switch 12 upon receiving a control signal, so that the charging switch 11 and the discharging switch 12 can receive the driving voltage Vdri. The charging switch 11 and the discharging switch 12 are turned on upon receiving the driving voltage Vdri, thereby connecting the cell module and the discharging terminal so that the cell module starts a charging or discharging process. The isolation switch 30 can output a driving voltage Vdri in response to the control signal, so as to drive the charging switch 11 and/or the discharging switch 12 to turn on, and can isolate a low-voltage control signal from the switch driving voltage signal, thereby avoiding signal interference between the logic control circuit and the switch driving circuit, and enhancing the stability and reliability of the switch driving circuit.

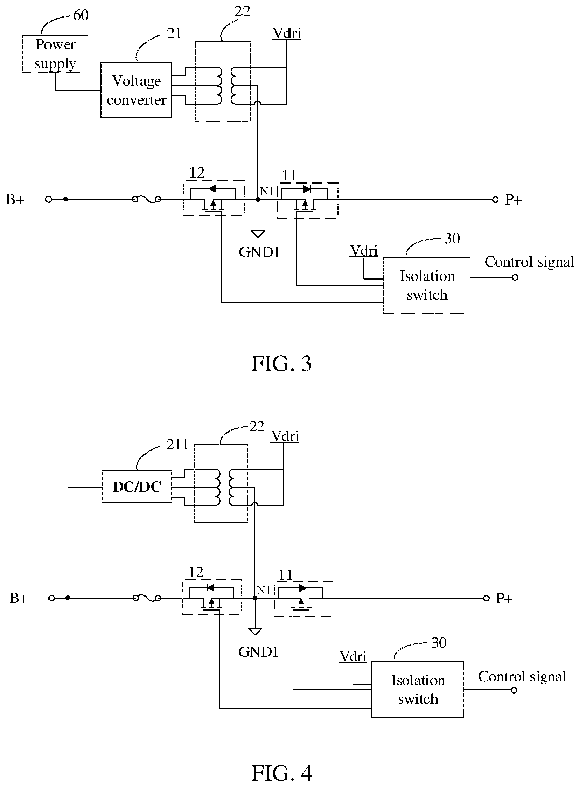

Referring to FIG. 2 and FIG. 3, in some embodiments, the driving voltage generation module 20 may include a voltage converter 21 and a transformer 22.

As shown in FIG. 2, in some embodiments, the input end of the voltage converter 21 is electrically connected to a main positive electrode B+ of the cell module, and the input end of the voltage converter 21 can receive the voltage of the cell module.

As shown in FIG. 3, in some other embodiments, the input end of the voltage converter 21 may be electrically connected to a power supply 60. When the input end of the voltage converter 21 is electrically connected to the power supply 60, the input end of the voltage converter 21 can receive a power supply voltage. The power supply 60 may be a DC power supply other than the cell module, such as a storage battery (the voltage of the storage battery may be 12 V, 24 V, or 48 V) or an emergency power supply (EPS).

The input end of the transformer 22 is connected to the output end of the voltage converter 21. A first output end of the transformer 22 is electrically connected to the first node N1, and a second output end of the transformer 22 is electrically connected to the isolation switch 30. Upon receiving the voltage of the cell module or the power supply voltage, the voltage converter 21 converts the voltage, and outputs the converted voltage to the input end of the transformer 22. The transformer 22 may transform the voltage at the input end, so as to output a driving voltage Vdri capable of driving the charging switch 11 and the discharging switch 12 to turn on.

A ratio of the voltage at the input end of the transformer 22 to the number of turns of the primary-side coil is the same as a ratio of the voltage at the output end of the transformer to the number of turns of the secondary-side coil. The voltage at the input end of the transformer 22 is the output voltage of the voltage converter 21, and the voltage at the output end of the transformer 22 is a voltage difference between the second output end and the first output end. Because the first output end of the transformer 22 is connected to the first node N1, the second output end outputs the driving voltage Vdri. The driving voltage Vdri is a sum of the voltage of the first node N1 and the voltage at the output end of the transformer 22. In other words, the transformer 22 can boost the voltage of the first node N1 on the basis of the voltage of the first node N1 with reference to the number of turns of the primary- and secondary-side coils and the output voltage of the voltage converter 21, so as to obtain the driving voltage Vdri, and output the driving voltage Vdri through the second output end, so as to drive the charging switch 11 or the discharging switch 12 to turn on.

Referring to FIG. 4, in some embodiments, the voltage converter 21 may include a DC-to-DC converter 211.

As shown in FIG. 4, the input end of the DC-to-DC converter 211 is electrically connected to the main positive electrode B+ of the cell module, and the output end of the DC-to-DC converter 211 is connected to the input end of the transformer 22. In an optional embodiment, the input end of the DC-to-DC converter 211 may be electrically connected to a power supply 60 instead.

When the input end of the DC-to-DC converter 211 is electrically connected to the main positive electrode B+ of the cell module, the DC-to-DC converter 211 can receive the voltage of the cell module and perform DC voltage conversion on the voltage to generate a corresponding DC voltage and output the DC voltage to the input end of the transformer 22.

When the input end of the DC-to-DC converter 211 is electrically connected to the power supply 60, the DC-to-DC converter 211 can receive a power supply voltage and perform DC voltage conversion on the power supply voltage to generate a corresponding DC voltage and output the DC voltage to the input end of the transformer 22.

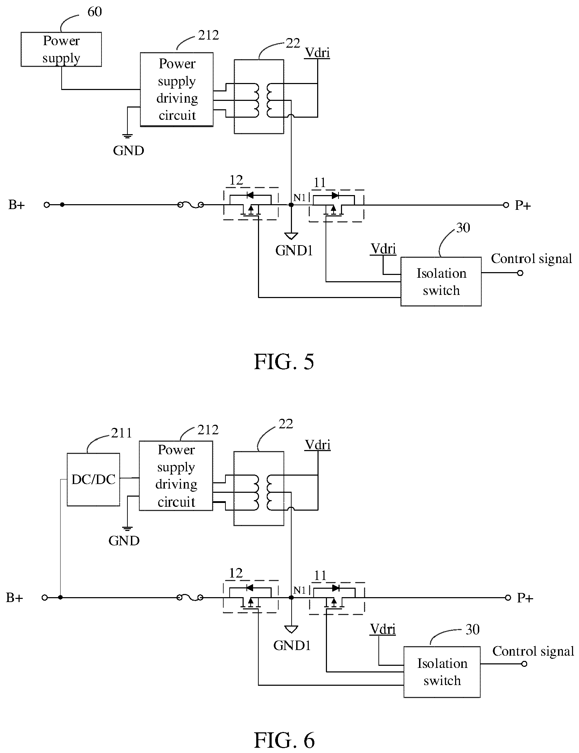

Referring to FIG. 5, in an optional embodiment, the voltage converter 21 may include a power supply driving circuit 212.

As shown in FIG. 5, the input end of the power supply driving circuit 212 is electrically connected to the power supply 60, and the output end of the power supply driving circuit 212 is connected to the input end of the transformer 22. In another optional embodiment, the power supply driving circuit 212 may be electrically connected to the main positive electrode B+ of the cell module.

The power supply driving circuit 212 may generate a voltage regulation signal, such as a PWM (Pulse width modulation, pulse width modulation) signal, and convert the received voltage of the cell module or the received power supply voltage based on the voltage regulation signal. The power supply driving circuit 212 may convert the received voltage based on a duty cycle of the PWM signal, so as to generate a corresponding appropriate DC voltage and output the DC voltage to the input end of the transformer 22.

Referring to FIG. 6, in an optional embodiment, the voltage converter 21 may further include a DC-to-DC converter 211 and a power supply driving circuit 212.

The input end of the DC-to-DC converter 211 is electrically connected to the main positive electrode B+ of the cell module or the power supply 60, and the output end of the DC-to-DC converter 211 is electrically connected to the power supply driving circuit 212. The output end of the power supply driving circuit 212 may be electrically connected to the input end of the transformer 22. After the DC-to-DC converter 211 performs voltage conversion on the voltage of the cell module or the power supply voltage for a first time, the power supply driving circuit 212 may perform a secondtime conversion on the voltage output by the DC-to-DC converter 211, so as to generate an appropriate DC voltage and output the DC voltage to the input end of transformer 22.

In order to enable the control end of the charging switch 11 and the control end of the discharging switch 12 to be turned on upon receiving the driving voltage Vdri, the voltage difference between the driving voltage Vdri and the voltage of the first node N1 needs to be greater than a threshold voltage of the charging switch 11 and a threshold voltage of the discharging switch 12. In a specific embodiment, the charging switch 11 and the discharging switch 12 are N-channel MOSFETs. The control ends of the charging switch 11 and the discharging switch 12 are gates. The gate voltage is the driving voltage Vdri, the source voltage is the voltage of the first node N1. When the voltage difference between the driving voltage Vdri and the voltage of the first node N1 is greater than a conductance threshold voltage of the MOSFET, the MOSFET can be turned on. In other words, the voltage at the output end of the transformer 22 needs to be greater than or equal to the conductance threshold voltage of the MOSFET.

In an embodiment, the parameters of the transformer 22 in the driving circuit generation module can be determined in advance. After the model of the transformer or the ratio between the primary turns and the secondary turns of the transformer is determined, in order to make the voltage at the output end of the transformer 22 greater than the conductance threshold voltage of the MOSFET, the voltage at the input end of the transformer 22 may also be adjusted to an appropriate voltage range.

In an optional embodiment, in order to prevent the voltage difference between the driving voltage Vdri and the voltage of the first node N1 from being close to the conductance threshold voltage of the MOSFET, where the closeness to the conductance threshold voltage affects the conduction status of the MOSFET in a case of voltage fluctuation, a voltage margin may be set on the basis of the conductance threshold voltage of the MOSFET. In a specific embodiment of this application, when the conductance threshold voltage of the MOSFET is approximately 3 V, the voltage that drives the MOSFET to turn on may be set to 9 V to 12 V. In other words, the voltage difference between the driving voltage Vdri and the voltage of the first node N1 may be approximately 9 V to 12 V The voltage at the output end of the transformer 22 can be determined based on the designed voltage difference between the driving voltage Vdri and the voltage of the first node N1.

In some other embodiments, when the voltage at the output end of the transformer 22 is definite, if a voltage transformation ratio of the transformer 22 is also determined, the voltage at the input end of the transformer may be further determined based on the voltage at the output end and the voltage transformation ratio. For example, when the voltage transformation ratio is 4 and the output voltage is 12 V, it can be determined that the voltage at the input end needs to be approximately 3 V. The voltage at the input end may be obtained by the voltage converter 21 by converting the voltage of the cell module or the power supply voltage.

To obtain an appropriate voltage at the input end, the voltage converter 21 may be a DC-to-DC converter 211 or a power supply driving circuit 212, or may be formed by connecting the DC-to-DC converter 211 and the power supply driving circuit 212 in series.

The DC-to-DC converter 211 may independently implement the conversion of the DC voltage, and the power supply driving circuit 212 may independently implement the conversion of the DC voltage. When the DC-to-DC converter 211 and the power supply driving circuit 212 are connected in series, the DC-to-DC converter 211 and the power supply driving circuit 212 may perform voltage conversion for two consecutive times to obtain a desired voltage, and provide the voltage to the input end of the transformer 22 for transformation, so that the driving voltage Vdri is generated on the basis of the voltage of the first node N1.

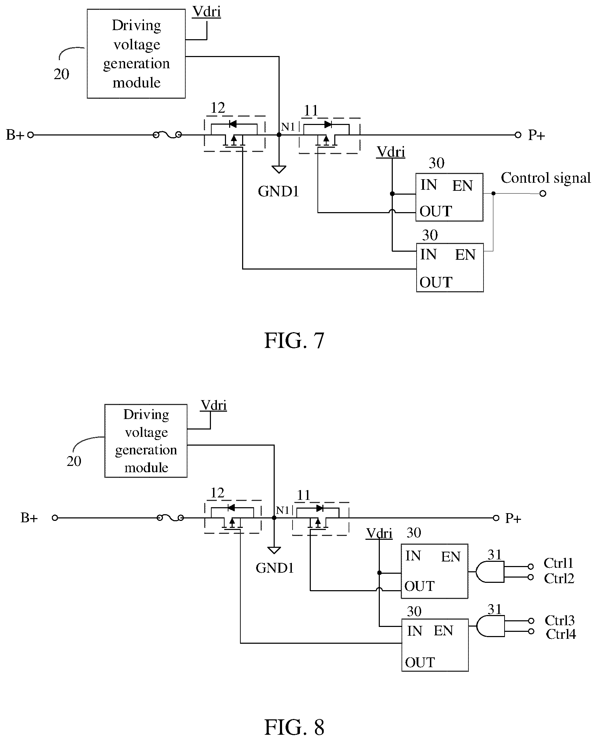

Referring to FIG. 7, in some embodiments, the isolation switch 30 may include an enabling end, an input end, and an output end. The input end of the isolation switch 30 is isolated from the enabling end of the isolation switch 30. The output end of the isolation switch 30 is also isolated from the enabling end of the isolation switch 30. The input end of the isolation switch 30 is electrically connected to the output end of the driving voltage generation module 20. The output end of the isolation switch 30 may be electrically connected to the control end of the charging switch 11 and the control end of the discharging switch 12 separately. The enabling end of the isolation switch 30 may receive a control signal and conduct the input end and the output end in response to the control signal, so that the driving voltage generation module 20 outputs a driving voltage Vdri to the charging switch 11 or the discharging switch 12. When the isolation switch 30 outputs the driving voltage Vdri to the control ends of the charging switch 11 and the discharging switch 12 through the output end, both the charging switch 11 and the discharging switch 12 are turned on.

Both the voltage at the input end and the voltage at the output end of the isolation switch 30 may be the driving voltage, and are higher than the voltage of the control signal at the enabling end of the isolation switch 30. The isolation switch 30 isolates the input end and the output end from the enabling end, thereby preventing the voltage signal of the switch driving circuit from flowing to the logic control circuit, and reducing the impact on the components (such as AFE and microcontroller unit) of the logic control circuit and the circuit.

Still referring to FIG. 7, in some embodiments, the switch driving circuit may include two isolation switches 30. Each isolation switch 30 includes an enabling end, an input end, and an output end.

The input end of each isolation switch 30 is isolated from the enabling end. The output end of each isolation switch 30 is also isolated from the enabling end. The input ends of the two isolation switches 30 are both electrically connected to the output end of the driving voltage generation module 20. The output end of one of the isolation switches 30 is electrically connected to the control end of the charging switch 11, and the output end of the other isolation switch 30 is electrically connected to the control end of the discharging switch 12.

The enabling ends of the two isolation switches 30 may receive the same control signal, or may receive different control signals separately. In some embodiments, the two isolation switches 30 receive the same control signal. One of the isolation switches 30 may output the driving voltage Vdri to the control end of the charging switch 11 in response to the control signal, so as to drive the charging switch 11 to turn on; and the other isolation switch 30 may output the driving voltage Vdri to the control end of the discharging switch 12 in response to the control signal, so as to drive the discharging switch 12 to turn on. In some other embodiments, the two isolation switches 30 receive two different control signals separately. For example, one isolation switch 30 receives a control signal from the AFE, and the other isolation switch receives a control signal from the microcontroller unit. One of the control signals may control one isolation switch 30 to drive the charging switch 11 to turn on, and the other control signal may control the other isolation switch 30 to drive the discharging switch 12 to turn on. By outputting corresponding control signals separately, the charging switch 11 or the discharging switch 12 may be turned on alone.

Referring to FIG. 8, in some embodiments, the switch driving circuit may further include at least one enabling circuit 31.

The input end of the enabling circuit 31 may be electrically connected to the analog front end, or to the microcontroller unit, or to both the analog front end and the microcontroller unit.

When the input end of the enabling circuit 31 is electrically connected to the analog front end, the enabling circuit 31 can respond to the control signal output by the analog front end, and output an enabling signal to the enabling end of the isolation switch 30, so that the isolation switch 30 is turned on in response to the enabling signal.

Similarly, when the input end of the enabling circuit 31 is electrically connected to the microcontroller unit, the enabling circuit 31 can respond to the control signal output by the microcontroller unit, and output an enabling signal to the enabling end of the isolation switch 30, so that the isolation switch 30 is turned on in response to the enabling signal.

In an optional embodiment, the input end of the enabling circuit 31 may be electrically connected to both the analog front end and the microcontroller unit. The enabling circuit 31 can output an enabling signal to the enabling end of the isolation switch 30 only when the analog front end outputs a control signal and the microcontroller unit also outputs a control signal, so that the isolation switch 30 is turned on in response to the enabling signal.

In an optional embodiment, the enabling circuit 31 may be an AND gate circuit formed of MOSFETs, or an AND gate circuit formed of transistors or other switch tubes, or a logic chip containing an AND gate.

In an optional embodiment, the two control signals received by the enabling circuit 31 may be control signals output by other modules.

In an optional embodiment, the enabling circuit 31 may receive three control signals or more than three control signals instead, and send the enabling signals to the corresponding isolation switch 30 when all the control signals are active enabling signals.

As shown in FIG. 8, the two enabling circuits 31 are connected to the enabling ends of the two isolation switches 30. The two isolation switches 30 are connected to the control end of the charging switch 11 and the control end of the discharging switch 12 separately.

When the analog front end outputs a control signal Ctrl1 and the microcontroller unit also outputs a control signal Ctrl2, the corresponding enabling circuit 31 can output an enabling signal to the enabling end of the isolation switch 30, so that the isolation switch 30 is turned on in response to the enabling signal and outputs a driving voltage Vdri to the control end of the charging switch 11.

When the analog front end outputs a control signal Ctrl3 and the microcontroller unit also outputs a control signal Ctrl4, the corresponding enabling circuit 31 can output an enabling signal to the enabling end of the isolation switch 30, so that the isolation switch 30 is turned on in response to the enabling signal and outputs a driving voltage Vdri to the control end of the discharging switch 12.

Through the two control signals of the analog front end and the microcontroller unit, the enabling circuit 31 is controlled to enable output. When either the analog front end or the microcontroller unit is abnormal and keeps outputting the control signal, the enabling circuit 31 will not output an enabling signal due to no receipt of the other control signal. In this way, when a device or chip in one control circuit of the two control signals fails, the charging switch 11 and the discharging switch 12 will not be controlled to turn on.

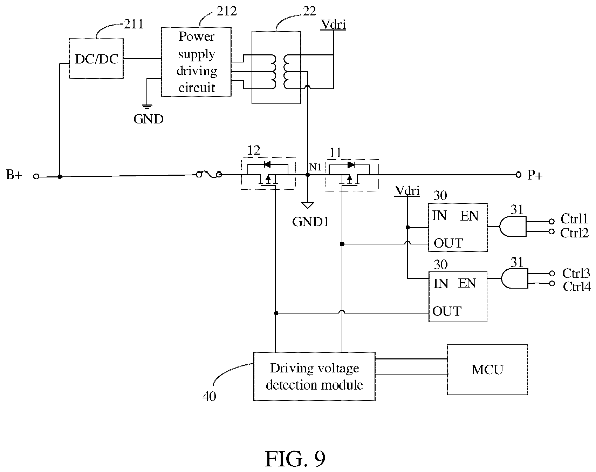

Referring to FIG. 9, in some embodiments, the switch driving circuit may further include a driving voltage detection module 40. The driving voltage detection module 40 may be electrically connected between the control end of the charging switch 11 and the microcontroller unit MCU. The driving voltage detection module 40 may also be electrically connected between the control end of the discharging switch 12 and the microcontroller unit MCU.

When the isolation switch 30 is turned on and outputs the driving voltage Vdri, the driving voltage detection module 40 can receive the driving voltage Vdri and output a corresponding detection signal to the microcontroller unit MCU. The microcontroller unit MCU can determine a relationship between the driving voltage Vdri and the threshold voltage based on the detection signal.

When the driving voltage detection module 40 is electrically connected between the control end of the charging switch 11 and the microcontroller unit MCU, if the isolation switch 30 is turned on, the driving voltage generation module 20 outputs the driving voltage Vdri to the control end of the charging switch 11 through the isolation switch 30. The driving voltage detection module 40 can also receive the driving voltage Vdri, compare the voltage value of the driving voltage Vdri with a preset threshold voltage, and output a corresponding detection signal to the microcontroller unit MCU based on a comparison result, so that the microcontroller unit MCU can determine the relationship between the driving voltage Vdri and the threshold voltage based on the detection signal.

Similarly, when the driving voltage detection module 40 is electrically connected between the control end of the discharging switch 12 and the microcontroller unit MCU, the driving voltage detection module 40 generates a detection signal in a manner similar to the manner of generating a detection signal when the driving voltage detection module is connected between the control end of the charging switch 11 and the microcontroller unit. The driving voltage detection module 40 can obtain the driving voltage Vdri received by the control end of the discharging switch 12, and output a corresponding detection signal to the microcontroller unit MCU unit based on a result of comparison between the driving voltage Vdri and the threshold voltage.

After receiving the detection signal, the microcontroller unit MCU unit may determine, based on the detection signal, whether the driving voltage Vdri is greater than the threshold voltage. If the driving voltage Vdri is less than the threshold voltage, the driving voltage Vdri is abnormal and unable to drive the charging switch 11 and the discharging switch 12 to turn on.

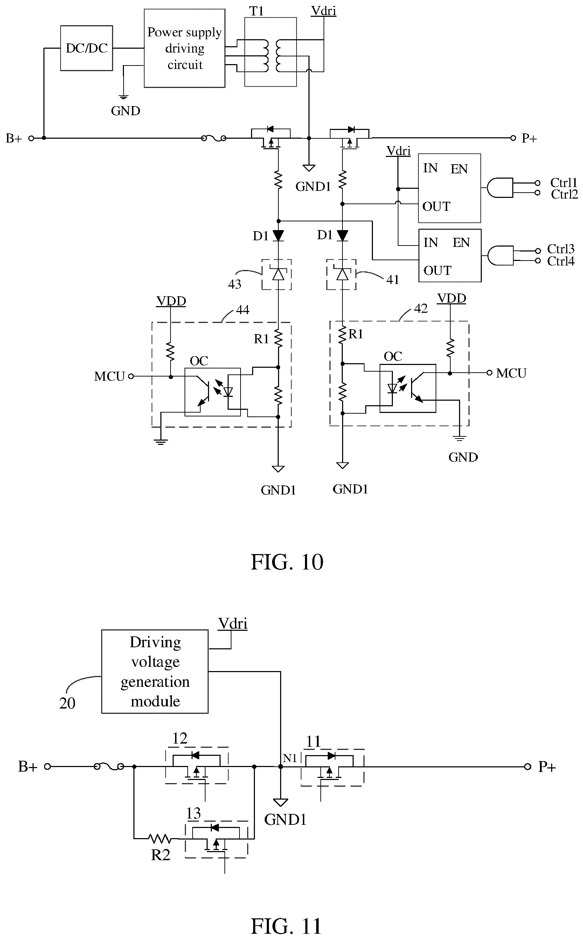

Referring to FIG. 10, in some embodiments, the driving voltage detection module 40 may include a first voltage regulator 41 and a first isolation element 42. A first end of the first voltage regulator 41 is electrically connected to the control end of the charging switch 11, and a second end of the first voltage regulator 41 is electrically connected to the isolation ground end GND1 by the first isolation element 42.

When the isolation switch 30 is turned on, the control end of the charging switch 11 may receive the driving voltage Vdri, and a breakdown voltage of the first voltage regulator 41 may be set as the threshold voltage. When the driving voltage Vdri is greater than the breakdown voltage of the first voltage regulator 41, the first isolation element 42 receives, through the first voltage regulator 41, the driving voltage Vdri reduced to the breakdown voltage. When the driving voltage Vdri is less than the breakdown voltage of the first voltage regulator 41, the first isolation element 42 is unable to receive the driving voltage Vdri. The first isolation element 42 may output a corresponding detection signal to the microcontroller unit MCU depending on whether the driving voltage Vdri is received, and then the microcontroller unit MCU determines the relationship between the driving voltage Vdri and the threshold voltage.

The first voltage regulator 41 may be a Zener diode. The first end of the first voltage regulator 41 is a negative electrode of the Zener diode, and the second end of the first voltage regulator 41 is a positive electrode of the Zener diode. By selecting Zener diodes with different breakdown voltages, the threshold voltage can be adjusted accordingly.

As shown in FIG. 10, the driving voltage detection module 40 may further include a second voltage regulator 43 and a second isolation element 44. A first end of the second voltage regulator 43 is electrically connected to the control end of the discharging switch 12, and a second end of the second voltage regulator 43 may be electrically connected to the isolation ground end GND1 by the second isolation element 44.

Similar to the functions of the first voltage regulator 41 and the first isolation element, the second isolation element 44 can receive the driving voltage Vdri when the control end of the discharging switch 12 receives the driving voltage Vdri if the driving voltage Vdri is greater than the breakdown voltage of the second voltage regulator 43. At this time, the voltage value of the driving voltage Vdri regulated by the second voltage regulator 43 is reduced to the voltage value of the breakdown voltage. If the driving voltage Vdri is less than the breakdown voltage of the second voltage regulator 43, the second isolation element 44 is unable to receive the driving voltage Vdri. The second isolation element 44 may output a corresponding detection signal to the microcontroller unit MCU depending on whether the driving voltage Vdri is received.

The driving voltage detection module 40 may include just the first voltage regulator 41 and the first isolation element 42 to detect the driving voltage Vdri at the control end of the charging switch 11. Alternatively, the driving voltage detection module 40 may include just the second voltage regulator 43 and the second isolation element 44 to detect the driving voltage Vdri at the control end of the discharging switch 12. Alternatively, the driving voltage detection module may include the first voltage regulator 41, the first isolation element 42, the second voltage regulator 43, and the second isolation element 44 simultaneously to detect the driving voltage Vdri at the control end of the charging switch 11 and the driving voltage Vdri at the control end of the discharging switch 12 respectively.

Still referring to FIG. 10, in some embodiments, the first isolation element 42 may include an optocoupler OC and a first resistor R1. An input end of the optocoupler OC and the first resistor R1 are connected in series between the second end of the first voltage regulator 41 and the isolation ground end GND1, and an output end of the optocoupler OC may be electrically connected to the microcontroller unit MCU.

When the driving voltage Vdri is greater than the breakdown voltage of the first voltage regulator 41, the input end of the optocoupler OC can receive the reduced driving voltage Vdri. At this time, the driving voltage Vdri is reduced to the breakdown voltage of the first voltage regulator 41. The input end of the optocoupler OC is connected to a light-emitting device. When the input end of the optocoupler OC receives the driving voltage Vdri, the light-emitting device emits light, so that a lightreceiving device receives the light and generates a corresponding current. When the microcontroller unit MCU is connected to the output end of the optocoupler OC, the microcontroller unit can receive the corresponding current signal and determine that the optocoupler OC is in an on-state, and then determine that the voltage value of the driving voltage Vdri is greater than the threshold voltage.

The first resistor R1 can serve a current limiting function to avoid damage to the optocoupler OC caused by a large current by the driving voltage Vdri flowing through the first voltage regulator 41 when the isolation switch 30 is turned on.

When the driving voltage Vdri is less than the breakdown voltage of the first voltage regulator 41, the light-emitting device of the optocoupler OC does not emit light, and the microcontroller unit MCU does not receive the corresponding current signal, thereby determining that the voltage value of the driving voltage Vdri is less than threshold voltage at this time.

The input end of the optocoupler OC is disposed between the control end of the charging switch 11 and the isolation ground end GND1. The voltage of the isolation ground end GND1 is the voltage of the first node N1. When the charging switch 11 and the discharging switch 12 are turned on, the voltage of the first node N1 is close to the voltage of the cell module. In other words, both the isolation ground end GND1 and the control end of the charging end 11 are high-voltage signal ends. The signal receiving end of the microcontroller unit MCU usually receives low-voltage signals. By disposing the optocoupler OC that isolates the microcontroller unit MCU from the driving signal, the relatively high driving voltage Vdri and the voltage of the first node N1 can be prevented from flowing into the microcontroller unit MCU, thereby preventing the microcontroller unit MCU from being damaged by high-voltage signals.

In an optional embodiment, the second isolation element 44 may include an optocoupler OC and a first resistor R1. Similar to the above embodiment of the first isolation element 42, the light-emitting device of the optocoupler OC in the second isolation element 44 can emit light when the driving voltage Vdri is greater than the threshold voltage, so that the microcontroller unit MCU receives a corresponding current signal and determines the relationship between the driving voltage Vdri and the threshold voltage.

In some embodiments, the driving voltage detection module 40 may further include at least one first diode D1.

When the driving voltage detection module 40 includes the first voltage regulator 41, the driving voltage detection module 40 may further include a first diode D1 corresponding to the first voltage regulator 41. The first diode D1 may be electrically connected between the control end of the charging switch 11 and the first voltage regulator 41. The first diode D1 enables the current to flow in a sole direction from the control end of the charging switch 11 to the first voltage regulator 41, thereby preventing a reverse current from affecting the conduction status of the charging switch 11.

When the driving voltage detection module 40 includes the second voltage regulator 43, the driving voltage detection module 40 may further include a first diode D1 corresponding to the second voltage regulator 43. In this case, the first diode D1 can serve a function of limiting the current direction between the control end of the discharging switch 12 and the second voltage regulator 43.

Referring to FIG. 11, in some embodiments, the switch driving circuit may further include a pre-discharging module. The pre-discharging module may include a pre-discharging switch 13 and a second resistor R2 that are connected in series. The pre-discharging module may be connected in parallel to the discharging switch 12.

When a discharging terminal is connected to a load, if the discharging switch 12 is turned on directly to output the voltage of the cell module to the load, the instantaneous discharging current will be excessive, thereby being prone to cause damage to the load and the discharging circuit. To avoid overcurrent damage, in a discharge process of the cell module, the pre-discharging switch 13 may be turned on first. At this time, the cell module is connected to the load through the pre-discharging switch 13 and the second resistor R2. The second resistor R2 can serve a function of limiting the current, so as to avoid excessive instantaneous current at the moment of connecting the cell module to the load. After the pre-discharging switch 13 has been on for a time period, the isolation switch 30 may be driven by a control signal to output the driving voltage Vdri to the discharging switch 12, so as to drive the discharging switch 12 to turn on. After the discharging switch 12 is turned on, the pre-discharging switch 13 may be turned off, so that the discharging circuit between the cell and the load is switched from the pre-discharging switch 13 to the discharging switch 12.

The control end of the pre-discharging switch 13 may also be connected to the output end of the isolation switch 30. The isolation switch 30 may output the driving voltage Vdri to the pre-discharging switch 13 in response to the control signal corresponding to the pre-discharging switch 13, so as to drive the pre-discharging switch 13 to turn on. After the pre-discharging switch 13 has been turned on for a time period, the driving voltage Vdri is output to the discharging switch 12, so as to drive the discharging switch 12 to turn on. After the discharging switch 12 is turned on, the output of the driving voltage Vdri to the control end of the pre-discharging switch 13 may be stopped, so as to turn off the pre-discharging switch 13.

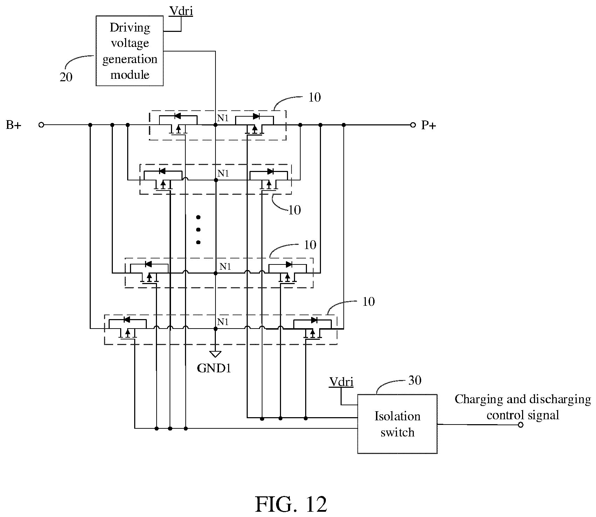

Referring to FIG. 12, in some embodiments, the switch driving circuit may include a plurality of switch units 10. Each of the switch units 10 may include a charging switch 11 and a discharging switch 12 that are connected in series. The switch unit 10 may be connected between the discharging terminal and the polarity terminal of the cell module. The plurality of switch units 10 may be connected in parallel to each other. The charging switch 11 and the discharging switch 12 in each switch unit 10 may be connected in series to the first node N1. The output end of the driving voltage generation module 20 may be electrically connected to the isolation ground end GND1 by the first node N1 of each switch unit 10. In other words, in all switch units 10, the node voltage of the first node N1 keeps consistent.

The isolation switch 30 may be electrically connected to the control end of each charging switch 11 and the control end of each discharging switch 12. When receiving the control signal that drives the charging switch 11 to turn on, the isolation switch 30 may connect the output end of the driving voltage generation module 20 to the control end of the charging switch 11 in each switch unit 10, so as to output the driving voltage Vdri to the control end of each charging switch 11, and in turn, drive a plurality of charging switches 11 to turn on simultaneously.

Similarly, when receiving the control signal that drives the discharging switch 12 to turn on, the isolation switch 30 may connect the output end of the driving voltage generation module 20 to the control end of the discharging switch 12 in each switch unit 10, so as to output the driving voltage Vdri to the control end of each discharging switch 12, and in turn, drive a plurality of discharging switches 12 to turn on simultaneously.

In this embodiment, the voltage of the first node N1 keeps consistent among all switch units 10. The driving voltage generation module 20 may boost voltage based on the voltage of the first node N1 to obtain a driving voltage Vdri. The isolation switch 30 in an on-state can output the driving voltage Vdri to the control end of the charging switch 11 and the control end of the discharging switch 12, so as to implement quick turn-on and quick turn-off of the charging switch 11 and the discharging switch 12, and in turn, improve the driving capability of the switch driving circuit. When a short-circuit abnormality is detected in the circuit containing the switch unit 10, the charging switch 11 and the discharging switch 12 can be quickly turned off to avoid damage to the devices in the circuit caused by an excessive current in the case of a short-circuit abnormality.

### Battery management system

An embodiment of this application provides a battery management system. The battery management system includes the switch driving circuit in the above embodiment. The switch driving circuit can generate a driving voltage through a driving voltage generation module. The isolation switch can perform conduction in response to a control signal, and output the driving voltage to the control end of the charging switch or the control end of the discharging switch. The voltage difference between the driving voltage and the voltage of the first node can drive the charging switch and the discharging switch to turn on, thereby controlling conduction of the charging switch and the discharging switch. The isolation switch can isolate a low-voltage control signal from a high-voltage driving voltage signal, thereby avoiding mutual interference between the high-voltage circuit and the low-voltage circuit, and enhancing the stability and reliability of the switch driving circuit.

The switch driving circuit has been described in detail in the preceding embodiment, and the detection principles of the switch driving circuit in the battery management system may be learned by referring to the description in the preceding embodiment, and are omitted here.

### Battery pack

An embodiment of this application provides a battery pack. The battery pack may include a cell module and the battery management system disclosed in the above embodiment. The cell module includes at least one battery cell. The battery management system is electrically connected to the cell module. When a discharging terminal is connected to a load or a charging device, the battery management system can drive the charging switch and the discharging switch to turn on, so as to connect the cell module and the load to implement discharging of the cell module, or connect the cell module and the charging device to implement charging of the cell module.

The switch driving circuit has been described in detail in the preceding embodiment, and the detection principles of the switch driving circuit in the battery pack may be learned by referring to the description in the preceding embodiment, and are omitted here.

### Electrical device

An embodiment of this application provides an electrical device, including the battery pack disclosed in the above embodiment. The electrical device may be an electric vehicle, an unmanned aerial vehicle, an electric bicycle, an electric tool, an energy storage system, or the like. The charging switch and discharging switch in the battery pack can be turned on as controlled by the battery management system, so as to implement charging and discharging of the battery pack.

The switch driving circuit has been described in detail in the preceding embodiment, and the detection principles of the switch driving circuit in the electrical device may be learned by referring to the description in the preceding embodiment, and are omitted here.

Understandably, the terms and expressions used herein are merely for ease of description, and one or more embodiments of this specification are not limited to such terms and expressions. The use of such terms and expressions is not intended to exclude any shown or described equivalent features (or a part thereof). It is hereby noted that various possible modifications are also included in the scope of the claims. Other modifications, changes, and substitutions are also possible. Accordingly, the claims are intended to cover all such equivalents.

## Claims

1. A switch driving circuit, **characterized in that** the switch driving circuit comprises:
a charging switch and a discharging switch, wherein the charging switch and the discharging switch are configured to be connected in series between a discharging terminal and a polarity terminal of a cell module;
a driving voltage generation module, wherein the driving voltage generation module, the charging switch, and the discharging switch are electrically connected to a first node, the first node is electrically connected to an isolation ground end, and the driving voltage generation module is configured to receive and convert a voltage of the cell module or a power supply voltage and generate a driving voltage; and
an isolation switch, wherein an input end of the isolation switch is electrically connected to an output end of the driving voltage generation module, and an output end of the isolation switch is electrically connected to a control end of the charging switch and/or a control end of the discharging switch, wherein
the isolation switch is configured to perform conduction in response to a control signal, and output the driving voltage to the control end of the charging switch and/or output the driving voltage to the control end of the discharging switch.

2. The switch driving circuit according to claim 1, **characterized in that**
the driving voltage generation module comprises a voltage converter and a transformer;
the input end of the voltage converter is configured to be electrically connected to the polarity terminal of the cell module or a power supply;
an input end of the transformer is electrically connected to an output end of the voltage converter, a first output end of the transformer is electrically connected to the first node, and a second output end of the transformer is electrically connected to the isolation switch; and
the transformer is configured to output the driving voltage.

3. The switch driving circuit according to claim 2, **characterized in that**
the voltage converter comprises a DC-to-DC converter,
an input end of the DC-to-DC converter is configured to be electrically connected to the polarity terminal of the cell module or the power supply, and an output end of the DC-to-DC converter is electrically connected to the input end of the transformer;
or,
the voltage converter comprises a DC-to-DC converter and a power supply driving circuit,
an input end of the DC-to-DC converter is configured to be electrically connected to the polarity terminal of the cell module or the power supply, an output end of the DC-to-DC converter is electrically connected to the power supply driving circuit, and an output end of the power supply driving circuit is electrically connected to the input end of the transformer;
or,
the voltage converter comprises a power supply driving circuit,
an input end of the power supply driving circuit is configured to be electrically connected to the polarity terminal of the cell module or the power supply, and an output end of the power supply driving circuit is electrically connected to the input end of the transformer.

4. The switch driving circuit according to any one of claims 1 to 3, **characterized in that**
the isolation switch comprises an enabling end, an input end, and an output end;
both the output end of the isolation switch and the input end of the isolation switch are isolated from the enabling end of the isolation switch, the input end of the isolation switch is electrically connected to the output end of the driving voltage generation module, and the output end of the isolation switch is electrically connected to the control end of the charging switch and the control end of the discharging switch separately.

5. The switch driving circuit according to claim 4, **characterized in that**
the switch driving circuit further comprises at least one enabling circuit;
an input end of the enabling circuit is electrically connected to an analog front end and/or a microcontroller, and an output end of the enabling circuit is electrically connected to the enabling end of the isolation switch; and
the enabling circuit is configured to output an enabling signal to the isolation switch in response to a control signal output by the analog front end and/or a control signal output by the microcontroller.

6. The switch driving circuit according to any one of claims 1 to 5, **characterized in that**
the switch driving circuit further comprises a driving voltage detection module;
the driving voltage detection module is electrically connected between the control end of the charging switch and the microcontroller, and/or the driving voltage detection module is electrically connected between the control end of the discharging switch and the microcontroller; and
the driving voltage detection module is configured to output a detection signal in response to the driving voltage, and the detection signal is used for indicating a relationship between the driving voltage and a threshold voltage.

7. The switch driving circuit according to claim 6, **characterized in that**
the driving voltage detection module comprises a first voltage regulator and a first isolation element,
a first end of the first voltage regulator is electrically connected to the control end of the charging switch, and a second end of the first voltage regulator is electrically connected to the isolation ground end by the first isolation element;
and/or,
the driving voltage detection module comprises a second voltage regulator and a second isolation element,
a first end of the second voltage regulator is electrically connected to the control end of the discharging switch, and a second end of the second voltage regulator is electrically connected to the isolation ground end by the second isolation element.

8. The switch driving circuit according to claim 7, **characterized in that**
the first isolation element comprises an optocoupler and a first resistor;
an input end of the optocoupler and the first resistor are connected in series between the second end of the first voltage regulator and the isolation ground end, and an output end of the optocoupler is electrically connected to the microcontroller;
and/or,
the second isolation element comprises an optocoupler and a first resistor;
an input end of the optocoupler and the first resistor are connected in series between the second end of the second voltage regulator and the isolation ground end, and an output end of the optocoupler is electrically connected to the microcontroller.

9. The switch driving circuit according to claim 7 or 8, **characterized in that**
the driving voltage detection module further comprises at least one first diode;
the at least one first diode is electrically connected between the control end of the charging switch and the first voltage regulator,
and/or,
the at least one first diode is electrically connected between the control end of the discharging switch and the second voltage regulator.

10. The switch driving circuit according to any one of claims 1 to 9, **characterized in that**
the switch driving circuit further comprises a pre-discharging module;
the pre-discharging module comprises a pre-discharging switch and a second resistor that are connected in series, and the pre-discharging module is connected in parallel to the discharging switch.

11. The switch driving circuit according to claim 10, **characterized in that**
a control end of the pre-discharging switch is connected to the output end of the isolation switch.

12. The switch driving circuit according to any one of claims 1 to 11, **characterized in that**
the switch driving circuit comprises a plurality of switch units;
each of the switch units comprises a charging switch and a discharging switch that are connected in series, and the switch unit is configured to be electrically connected between the discharging terminal and the polarity terminal of the cell module; and
the plurality of switch units are connected in parallel;
the first node is disposed between the charging switch and the discharging switch in each switch unit, and the output end of the driving voltage generation module is electrically connected to the isolation ground end by the first node; and
the isolation switch is electrically connected to the control end of each charging switch and the control end of each discharging switch.

13. A battery management system, **characterized in that** the battery management system comprises the switch driving circuit according to any one of claims 1 to 12.

14. A battery pack, comprising a cell module and the battery management system according to claim 13, and the cell module is electrically connected to the battery management system.

15. An electrical device, comprising the battery pack according to claim 14.
